# EUROPEAN PATENT SPECIFICATION

(11) **EP 0 403 274 B1**
(45) Date of publication and mention of the grant of the patent: **12.10.1994**
(21) Application number: 90306479.8
(22) Date of filing: 14.06.1990
(51) Int. Cl.: H01L 27/118

(54) **Semi-custom integrated circuit device**
Integrierte Kundenwunschschaltungsvorrichtung
Dispositif de circuit intégré prédiffusé

(30) Priority: 14.06.1989 JP 149473/89
(43) Date of publication of application: 19.12.1990
(73) Proprietor: FUJITSU LIMITED, Kawasaki-shi, Kanagawa 211 (JP)
(72) Inventor: Tomita, Masayoshi, Nakahara-ku, Kawasaki-shi, Kanagawa 211 (JP); Saitoh, Tadahiro, Tama-ku, Kawasaki-shi, Kanagawa 214 (JP); Hasegawa, Kiyokazu, Midori-ku, Yokohama-shi, Kanagawa 227 (JP); Kosugi, Noboru, Takatsu-ku, Kawasaki-shi, Kanagawa 213 (JP)
(74) Representative: Fane, Christopher Robin King

(56) References cited:
- EP-A- 0 189 183
- PATENT ABSTRACTS OF JAPAN, vol. 9, no. 136 (E-320)[1859], 12th June 1985 ; & JP-A-60 18 932
- PATENT ABSTRACTS OF JAPAN, vol. 9, no. 201 (E-336)[1924] 17th August 1985 ; & JP-A-60 66 449
- PATENT ABSTRACTS OF JAPAN, vol. 10, no. 99 (E-396)[2156], 16th April 1986 ; & JP-A-60 240 139
- IEEE J. Solid-State Circuits, vol. 24, no. 3, June 1989, pages 576-584

## Description

The present invention relates to a semi-custom integrated circuit apparatus capable of discretionally forming a gate array of a digital circuit (logic circuit), a gate array of an analog circuit, or a gate array on which a digital circuit and an analog circuit are mixed.

### Description of the Related Art

In the present art, a gate array on which a logic circuit is provided forms the main current. Furthermore, in a recently developed device, a gate array on which an analog circuit is provided has both a digital circuit and an analog circuit formed on the gate array.

Generally, it is necessary in an analog circuit to provide a resistor or a capacitor in addition to a transistor.

The number of prior-art devices having the gate array in which a digital circuit and an analog circuit are mixed is very small. However, an example of this type of device is the invention disclosed in Japanese Patent Disclosure sho 59-1083228, which has a capacitor formed in a wire layer of the cell array.

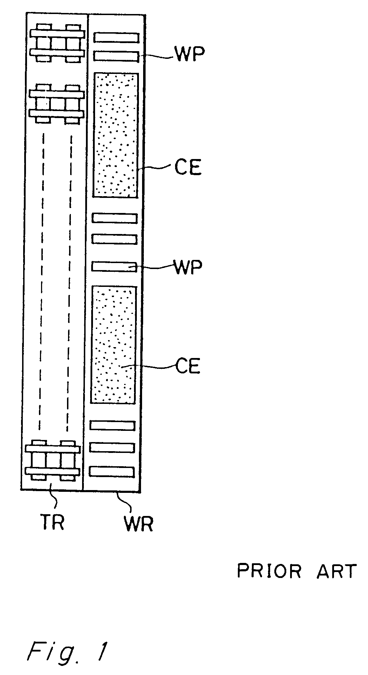

Figure 1 represents a plan view of a main part of a cell array in a semi-custom IC disclosed in this Japanese Patent Disclosure.

In Figure 1, TR represents a transistor region, WR a wiring region, WP a wiring poly-silicon film and CE a capacitor poly-silicon film.

One electrode of the capacitor is formed of the capacitor poly-silicon film CE of the other electrode of the capacitor is formed of an impurity diffusion region with a bulk form. A resistor can be formed by deriving two electrodes from the impurity diffusion region.

In a semi-custom integrated circuit, respective cells must have a rectangular shape to enable the arrangement and wiring to be designed by a computer. Respective regions with a bulk form are fixed. Only the wiring is changed to enable the device to be provided with different functions.

As described above, where a digital circuit is mixed with an analog circuit, the above condition which includes provision of a resistor and capacitor, which are essential for the construction of an analog circuit, should be maintained.

For this purpose, it is important to provide a layout which includes a resistor and a capacitor. Needless to say, the prior art invention disclosed in the above patent disclosure is limited to the idea in which a digital circuit and an analog circuit are merely mixed. Therefore, in this prior art, the arrangement of the resistor and capacitor is not regular. Thus, it requires an unnecessarily large space, thereby drastically decreasing the number of cells with an analog function which can be provided in the cell. In particular, this prior art does not clearly specify the wiring and thus does not solve the wiring problem. Thus, as can be seen from the above, the prior art has serious problems which may make it impossible to realize a gate array on which a digital circuit and analog circuit can be mixedly mounted.

JP-A-60 18932 by Suwa Seikosha K.K. discloses a gate array device in accordance with the preamble of each independent claim. In this device, two "cells" are separated by a single resistance element and a single capacitance element.

According to a first aspect of the present invention, there is provided a semi-custom integrated circuit comprising an array of circuit elements arranged in a line, said elements comprising transistor units, capacitor units and resistor units, said transistor unit having a gate electrode, and each of said transistor unit, capacitor unit and resistor unit having one or more respective terminal portions for connection of wiring;
wherein said transistor unit comprises a source region and a drain region arranged in said first direction, said gate electrode provided between said source region and drain region and extending in a second direction which is perpendicular to said first direction and said gate electrode having terminal portions in a terminal region;
characterised in that:-
said array is a basic cell array consisting of a plurality of basic cells aligned in a first direction, each basic cell having a said capacitor unit, a said resistor unit, and a said transistor unit positioned between the capacitor unit and resistor unit;
wherein said terminal portions of said transistor unit, capacitor unit and said resistor unit are aligned along a straight line in said second direction.

According to a second aspect of the present invention, there is provided a semi-custom integrated circuit comprising an array of circuit elements arranged in a line, said elements comprising transistor units, capacitor units and resistor units, wherein:
said array is a basic cell array consisting of a plurality of first basic cells and a plurality of second basic cells aligned in a first direction,
each first basic cell comprising
a first resistor unit, a second resistor unit and
a transistor unit positioned between said first resistor unit and said second resistor unit;
wherein said transistor unit comprises a source region and a drain region arranged in said first direction, a gate electrode provided between said source region and drain region and extending in a second direction which is perpendicular to said first direction; each of said transistor unit, first resistor unit and second resistor unit having one or more respective terminal portions for connection of wiring;
wherein said terminal portions of said transistor unit, first resistor unit and second resistor unit are aligned along a straight line in said second direction, and
each second basic cell comprising
a first capacitor unit, a second capacitor unit and a further transistor unit positioned between said first capacitor unit and said second capacitor unit;
wherein said further transistor unit comprises a source region and a drain region arranged in said first direction, a gate electrode provided between said source region and drain region and extending in said second direction; each of said further transistor unit, first capacitor unit and second capacitor unit having one or more terminal portions for connection of wiring;
wherein said terminal portions of said further transistor unit, first capacitor unit and second capacitor unit are aligned along a straight line in said second direction.

Reference is made, by way of example, to the accompanying drawings in which:
Figure 1 shows a plan view of the main part of a cell array in a semi-custom IC disclosed in the prior art,
Figures 2A and 2B, respectively show a plan view of the main part of a basic cell for explaining the principle of the present invention and an equivalent circuit thereof,
Figure 3 shows a plan view of the main part of an array for explaining one embodiment of an arrangement of a resistor unit and a capacitor unit and that of a basic cell,
Figure 4 shows a plan view of the main part of an array for explaining another embodiment of an arrangement of a resistor unit and a capacitor unit and that of a basic cell,
Figure 5 shows a plan view of the main part of an array for explaining a further embodiment of an arrangement of a resistor unit and a capacitor unit and that of a basic cell,
Figure 6 shows a plan view of the main part of an array for explaining a still further embodiment of the arrangement of a resistor unit and a capacitor unit and that of a basic cell,
Figure 7 shows a plan view of the main part of an array for explaining other embodiment of an arrangement of a resistor unit and a capacitor unit and that of a basic cell,
Figure 8 shows a plan view of the main part of an array for explaining an embodiment in which the width of a transistor unit is different from that of the resistor unit or the capacitor unit,
Figure 9 shows a plan view of the main part of an array for explaining another embodiment in which the width of the transistor unit is different from that of the resistor unit or capacitor unit,
Figures 10A and 10B, respectively, show a plan view of the main part of the basic cell for explaining the embodiment of the present invention and an equivalent circuit thereof,
Figure 11 is a sectional view of the main part of the embodiment along the line Y1-Y1 shown in Figure 10A,
Figure 12 shows a sectional side view of the main part of the embodiment along the line X-X shown in Figure 10A,
Figure 13 is a sectional view of the main part of the embodiment along the line Y2-Y2 shown in Figure 10A,
Figure 14 shows a sectional view of the main part of the embodiment along the line Y3-Y3 shown in Figure 10A,
Figures 15 shows a plan view of the main part of the embodiment for explaining a pattern layout of an operational amplifier to which the present invention is applied,
Figure 16 shows an equivalent circuit of the operational amplifier shown in Figure 15 as the pattern layout and,
Figure 17 shows a plan view of the main part of the whole bulk for explaining the gate array according to the present invention.

### Preferred Embodiment of the Present Invention

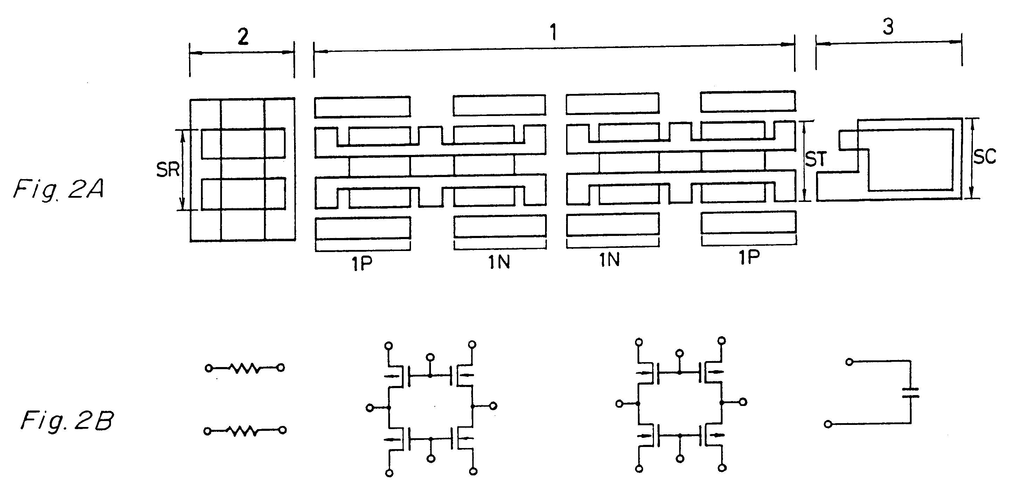

Figures 2A and 2B, respectively, show a plan view of a main part of a basic cell for explaining the principle of the present invention and equivalent circuit thereof.

In the drawing, 1 is a transistor unit, 1p a p-channel transistor portion, 1n an n-channel transistor portion, 2 a resistor unit, 3 a capacitor unit, ST the width of the transistor unit 1, SR the width of the resistor unit 2, and SC the width of the capacitor unit 3.

As described above, in the present invention, transistor unit 1, resistor unit 2, and capacitor unit 3 are combined to form a single basic cell and the basic cell is arranged as an array.

The basic cell shown in Figure 2A provides resistor unit 2 on the left side of transistor unit 1 and capacitor unit 3 on the right side thereof. The structure of the basic cell can be modified in various ways and the arrangement of the basic cell can be selected appropriately as necessary. The number of transistors may be one or more than one.

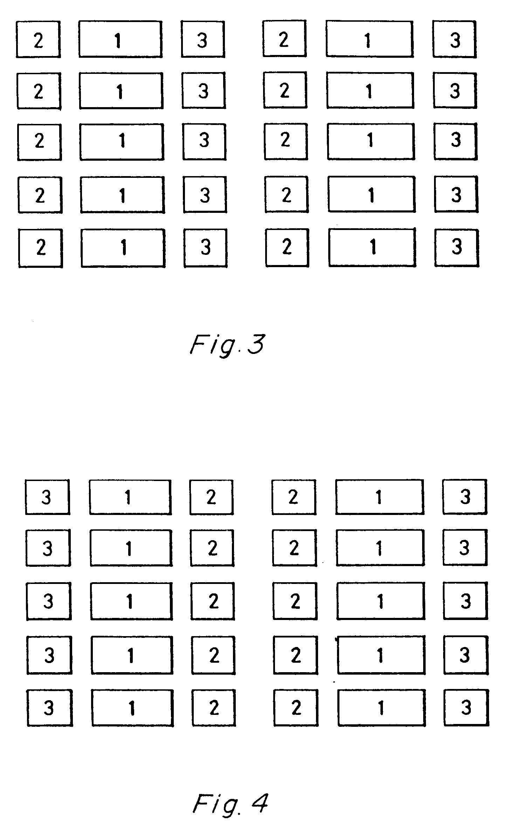

Figures 3 to 7 represent explanatory plan views of the main part of an array for explaining the arrangement of the resistor 2 and the capacitor unit 3 and an array of the basic cell. The same reference numbers as used in Figure 2A represent the same portions or the same meanings.

Figure 3 represents an array in which the basic cell shown in Figure 2A is sequentially arranged.

Figure 4 represents an array of a basic cell in which the positions of the capacitor unit 3 and resistor unit 2 are exchanged with those of the resistor unit 2 and capacitor unit 3 of the basic cell shown in Figure 3, such array of the basic cell being provided in one column. The array of the basic cell shown in Figure 3 is provided in the adjacent column.

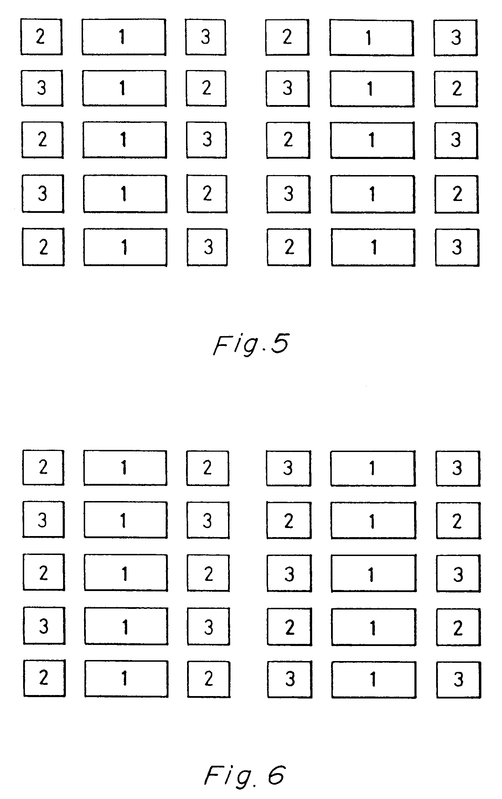

Figure 5 represents an array in which the basic cell shown in Figure 3 and the basic cell shown in Figure 4 are provided in turn.

Figure 6 shows an array in which a basic cell having resistor units 2 provided on both sides of the transistor unit 1 and a basic cell having capacitor units 3 provided on both sides of the transistor unit 1 are arranged in turn and the basic cell array on the left side is shifted from the basic cell array on the right side by one basic cell.

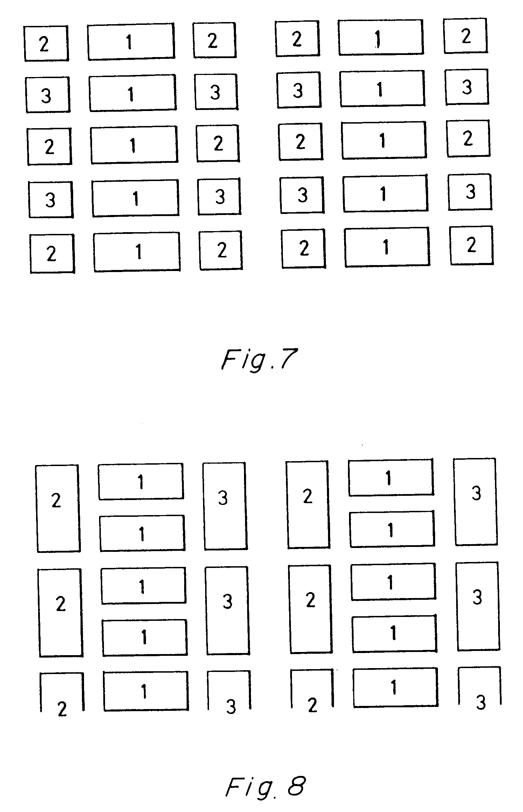

Figure 7 represents an array in which the basic cell array on the left side becomes the same basic cell array on the right side in the array relationship shown in Figure 6.

In the basic cell shown in Figures 2 to 7, the width ST of the transistor unit 1 is equal to the width SR of resistor unit 2 and the width SC of capacitor unit 3, but the widths ST, SR and SC can be properly selected within a scope facilitating a computer aided design.

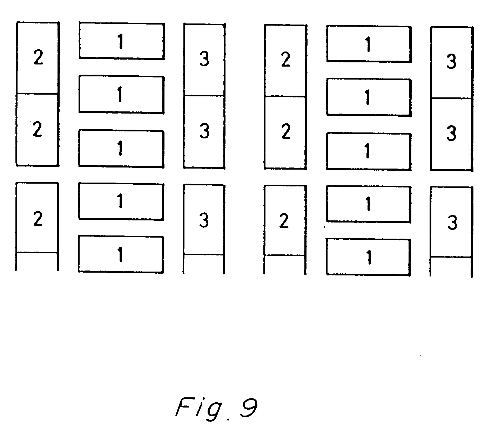

Figures 8 and 9 are an explanatory main part plan views relating to an array for explaining a case in which the width SR of resistor unit 2 and the width SC of capacitor unit 3 are not equal to the width ST of transistor unit 1. The reference numbers shown in Figures 8 and 9, which are the same as those shown in Figures 3 to 7, represent the same part or the same meaning.

In Figure 8, the width SR of the resistor unit 2 and the width SC of the capacitor unit 3 are a positive natural number times the width ST the of transistor unit 1.

Figure 9 represents an array in which the width SR of resistor unit 2 and the width SC of capacitor unit 3 are a positive natural number times half the width ST of the transistor unit 1.

Where the gate array is of a channel type, the basic cell forms the transistor unit 1 in the transistor area TR and forms the resistor unit 2 and capacitor unit 3 so that they are buried in the wiring region WR. If the gate array is of a channelless type (i.e. a sea of gate: SOG), the basic cell is provided over the entire area.

As is clear from the above description, in the semi-custom integrated circuit device according to a first embodiment of the present invention as viewed in the plan direction, a resistor unit (for example, the resistor unit 2) or capacitor unit (for example, the capacitor unit 3) is provided on both sides of a transistor unit (for example, the transistor unit 1). The vertical width of these units is either the same as the vertical width (for example, the width ST) of the transistor unit, a positive natural number times the vertical width of the transistor unit or positive natural number times half the vertical width of the transistor unit. This assembly forms a basic cell. In addition, a transistor unit may be provided in the transistor region and the resistor or capacitor units may be provided in the wiring region provided beside the transistor region.

By this means, a semi-custom integrated circuit apparatus on which a digital circuit and an analog circuit can be independently or mixedly mounted is realized and the wire for completing an integrated circuit device which can be provided to a user can be dealt with by using the conventional technology.

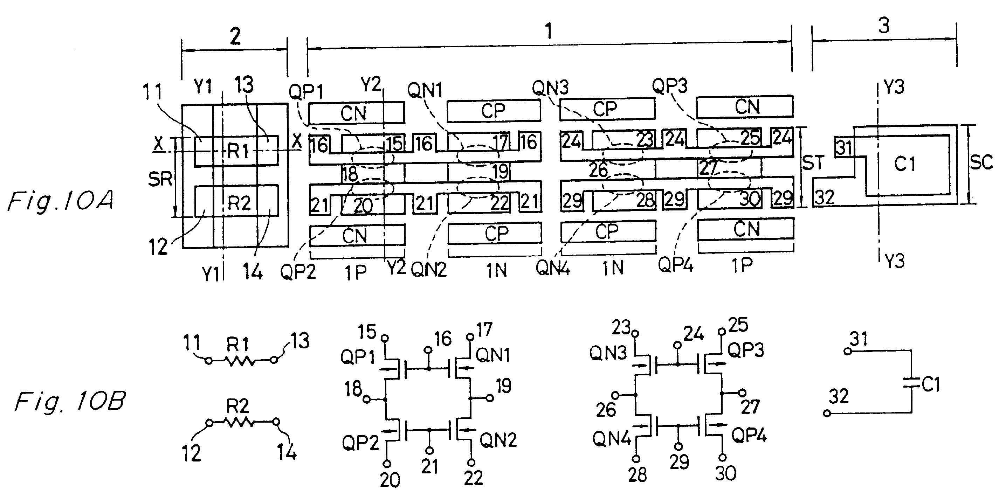

Figures 10A and 10B, respectively, represent a plan view and an equivalent circuit view of a main part of a basic cell for explaining an embodiment of the present invention and the same references used in Figures 2 to 9 represent the same parts or meanings.

The present embodiment is basically the same as the basic cell explained by referring to Figure 2. Needless to say, the symbols in Figure 10A correspond to the symbols shown in Figure 10B.

In Figures 10A and 10B, 11 to 32 indicate terminals, R1 and R2 resistors, QP1 and QP2 p-channel and QN2 n-channel transistors, QP3 and QP4 q-channel transistors, QN3 and QN4 n-channel transistors, C1 a capacitor, CP a contact pattern for connection to a p-type substrate and CN a contact pattern for connection to an n-type substrate. Respective transistors in Figures 10A and 10B are represented by their gates and symbols are given to their gates.

An impurity diffused region R1 of the resistor unit 2 is to form a resistor R1. The regions 11 and 13 are to form terminals 11 and 13 of the resistor R1. Regions 16 and 21 are to form gate terminals 16 and 21 of the transistors QP1 and QP2. Regions 15 and 20 are to form source terminals 15 and 20. Region 18 is to form drain electrode 18. Regions 31 and 32 are to form terminals 31 and 32 of capacitor C1.

The regions for terminals 11,13, 16 and 24 are aligned with each other. The regions for terminals 12,14, 21, 29 and 32 are aligned with each other. Therefore terminals of the resistor unit 2, transistor unit 1 and capacitor unit 3 are aligned with each other in a horizontal direction, for example, analog a line of a grid (not shown). Contact patterns CN and CP are also aligned in a horizontal direction. Some of the terminals or contact patterns may be aligned in a vertical direction. Therefore, the embodiment shown in Figure 10A facilitates computer aided design and wiring.

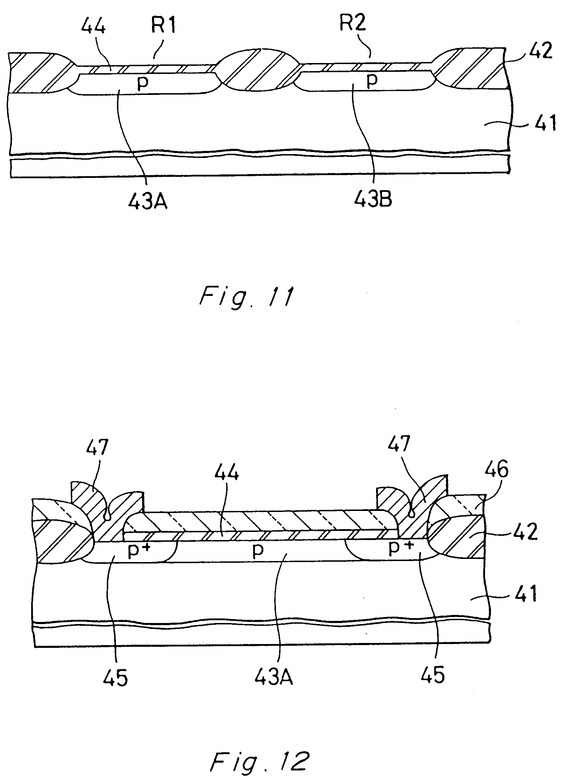

Figure 11 is a sectional view of a main part along the line Y1-Y1 shown in Figure 10A and the same reference numbers as in Figures 2 and 10A represent the same parts as in Figures 2 to 10A.

In Figure 11, 41 indicates an n type semiconductor substrate, 42 a field insulating film comprising a silicon dioxide (Sio₂), 43A and 43B are p-type resistor regions and 44 an insulating film formed simultaneously with a gate insulating film.

Figure 12 is a sectional view of the main part along the line x-x shown in Figure 10A and the same references as used in Figure 2 to 11 represent the same parts or the same meanings.

In Figure 12, 45 indicates a p⁺-type electrode contact region, 46 a phosphosilicate glass(PSG) film and 47 an electrode.

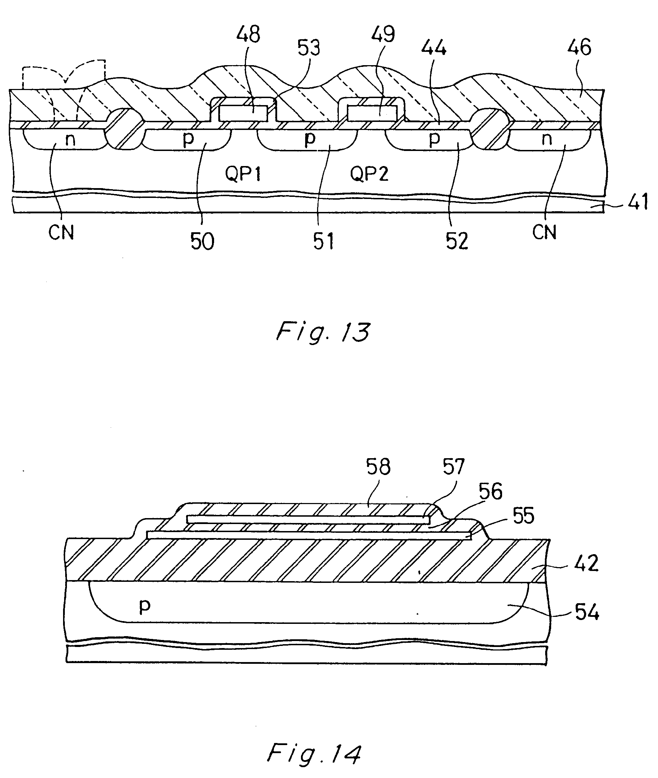

Figure 13 is a sectional view of the main part along the line Y2-Y2 shown in Figure 10A. The same reference numbers as used Figures 2 to 12 represent the same parts or the same meanings.

In Figure 13, 48 indicates a polisilicon gate electrode of transistor QP1, 49 a polisilicon gate electrode of transistor QP2, 50 a p-type source region of transistor QP1 and QP2, 51 a p-type drain region of transistors Q1, 52 a p-type drain region of transistor AP2, and 53 a between-layer insulating film comprising Sio₂.

Figure 14 is a sectional view of the main part along the line Y-3 shown in Figure 10A. The same reference numbers as in Figures 2 to 13 represent the same parts or the same meanings.

In Figure 14, 54 indicates a p-type region, 55 a capacitor electrode of polysilicon, 56 a capacitor dielectric film comprising Sio₂, 57 a capacitor electrode of a polysilicon and 58 an insulating film.

As described above, when a capacitor is formed of a 2-layer configuration comprising polysilicon films, the accuracy of the capacitance is higher than that of a capacitor formed by bulk polysilicon and a single-layer polysilicon film. Where a high-precision capacitor or resistor is obtained, it becomes possible to form a D/A converter of the R-string type or an A/D converter of the sequential comparison type by using the cell of the present invention. Therefore, an integrated circuit unit device can be completed within a short period in the same manner as an ordinary gate array.

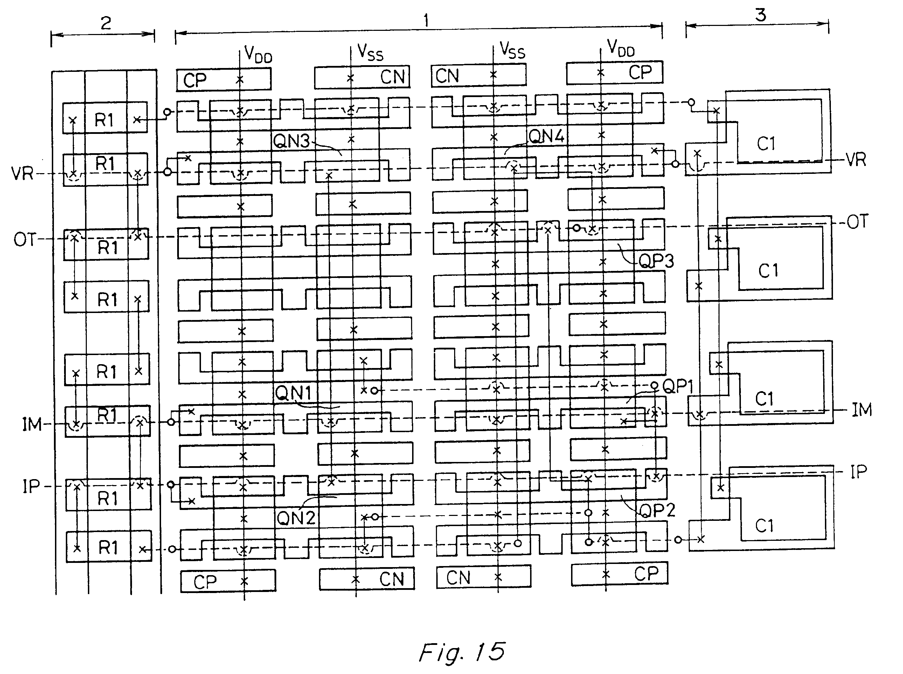

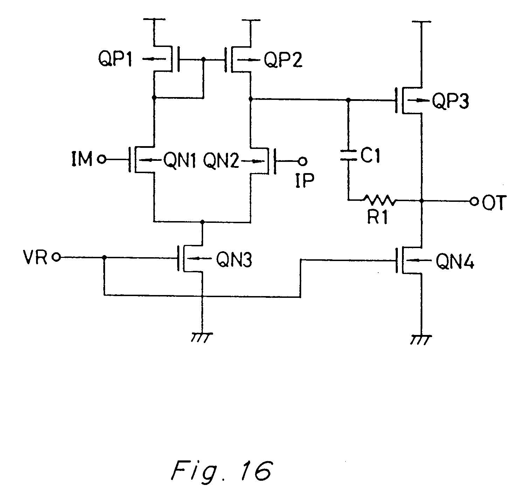

Figures 15 and 16 represent a plan view of the main part for explaining the pattern layout of an operational amplifier formed by and the equivalent circuit diagram the basic cell of the present invention. The reference numbers as used in Figures 1 to 13 represent the same parts or the same meanings.

In Figures 14 and 15, V_{DD} represents a positive power source level, Vss a ground side power source level, IM a -difference input, IP a +difference input, VR a bias input and OT an output. The wire represented by a solid line is made of metal wire and it is in the first layer Aℓ. The wire represented by a dashed line is also made of metal and is in the second layer Aℓ. The x mark indicates the contact portion between the first-layer metal wire and the bulk, and the O mark designates the contact point between the first-layer metal wire and the second-layer metal wire.

As is clear from the drawings, the basic cell in this embodiment is the same as that, used for the explanation in Figures 2 to 4. Transistor unit 1, resistor unit 2 and capacitor unit 3 can be wired by computer-aided automatic design.

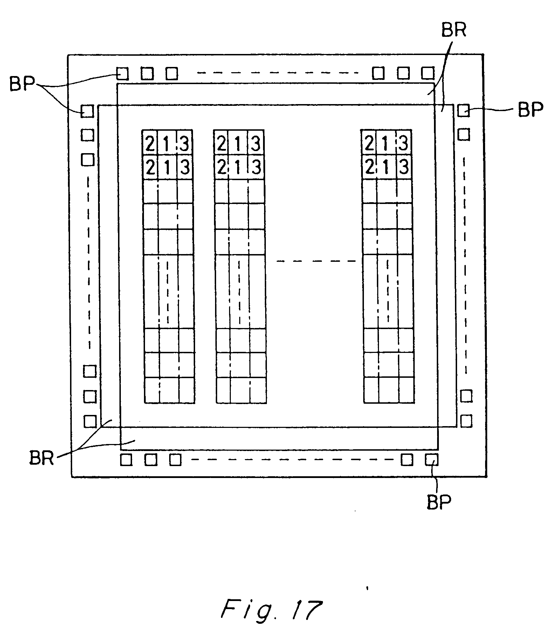

Figure 17 is an explanatory plan view of the main part representing the whole bulk for explaining a gate array embodying the present invention. The same reference numbers used in Figures 2 to 16 represent the same portions or the same meanings.

In Figure 17, BR represents an input and output buffer and BP an input and output bonding pad.

In Figure 17, when the gate array is used only for a logic circuit, resistor unit 2 and capacitor unit 3 in the basic cell need not be used. Further more, if the gate array is used only for an analog circuit, the whole basic cell can be used. If they are selectively embodied, a gate array in which a logic circuit and an analog circuit are mixed can be realized. When the gate array is formed only by the logic circuit, it does not cause any problem even if a metal wire passes over resistor unit 2 or capacitor unit 3.

The basic cell of the present invention can also form A/D or D/A converter, analog switch, and comparator, for example.

The basic cell of the present invention may be used for a full-custom integrated circuit device and a regular standard integrated circuit device.

Digital and the analog circuits can be independently or mixedly mounted, thereby providing semiconductor integration. The wiring required to complete an integrated circuit device to be provided to a user, can be dealt with by automatic computer aided design using the conventional technology.

## Claims

1. A semi-custom integrated circuit comprising an array of circuit elements arranged in a line, said elements comprising transistor units, capacitor units and resistor units, said transistor unit having a gate electrode, and each of said transistor unit, capacitor unit and resistor unit having one or more respective terminal portions for connection of wiring;
characterised in that:-
said array is a basic cell array consisting of a plurality of basic cells aligned in a first direction, each basic cell having a said capacitor unit, a said resistor unit, and a said transistor unit positioned between the capacitor unit and resistor unit;
wherein
said transistor unit comprises:
a source region and a drain region arranged in said first direction,
said gate electrode provided between said source region and drain region and extending in a second direction which is perpendicular to said first direction, and
said gate electrode having terminal portions in a terminal region;
wherein said terminal portions of said transistor unit, capacitor unit and said resistor unit are aligned along a straight line in said second direction.

2. The semi-custom integrated circuit according to claim 1, wherein
a plurality of said cell arrays are arranged in said second direction crossing a wiring region.

3. The semi-custom integrated circuit according to claim 1, wherein an unused region of said capacitor unit or transistor unit is used for the arrangement of interconnection wiring between said basic cells.

4. The semi-custom integrated circuit according to claim 1, wherein
said resistor unit comprises a polysilicon layer formed on an insulating film covering a semiconductor substrate and extending in said second direction and having a terminal portion, and
said capacitor unit comprises a first electrode formed on the insulating film for covering said semiconductor substrate, an insulating film for covering a first electrode and a second electrode formed on said insulating film, said first and second electrodes having respective terminal portions.

5. The semi-custom integrated circuit according to claim 1, wherein
said transistor unit comprises a p-channel MIS-transistor pair and an n-channel MIS transistor pair arranged in said second direction,
said p-channel MIS transistor pair comprises a first p-type region, a second p-type region, and a third p-type region, which are arranged in said first direction, a first gate electrode arranged between said first p-type region and said second p-type region and extending in said second direction and a second gate electrode arranged between said second p-type region and said third p-type region and extending in said second direction,
said n-channel MIS transistor pair comprises a first n-type region, a second n-type region, and a third n-type region, which are arranged in said first direction, a third gate electrode arranged between said first n-type region and said second n-type region and extending in said second direction, and a fourth gate electrode arranged in said second n-type region and said third n-type region and extending in said second direction,
said resistor unit comprises a first resistor element and a second resistor element arranged in said first direction and extending in said second direction,
said capacitor unit has a first capacitor electrode and a second capacitor electrode,
terminal portions of the first and the third gate electrodes, said first p-type region, said first n-type region, said first resistor element, and said first capacitor electrode are aligned along a line in said second direction, and
terminal portions of the second and fourth gate electrodes, said third p-type region, said third n-type region, said second resistor element, and said second capacitor electrode are aligned with each other, and the terminal portions of said second p-type region and said second n-type region are aligned along a line in said second direction.

6. The semi-custom integrated circuit according to claim 5, wherein
said first and third gate electrodes are formed of an integrated electrode and said second and fourth electrodes are formed of another integrated electrode.

7. The semi-custom integrated circuit according to claim 1, wherein
said transistor unit comprises first and second p-channel MIS transistor pairs and first and second n-channel MIS transistor pairs arranged in said second direction,
said first and second p-channel MIS transistor pairs each comprise a first p-type region, a second p-type region and a third p-type region arranged in said first direction, a first gate electrode arranged between said first p-type region and said second p-type region and extending in said second direction, and a second gate electrode arranged between said second p-type region and said third p-type region and extending in said second direction,
said first and second n-channel MIS transistor pair each has a first n-type region, a second n-type region and a third n-type region arranged in said first direction, a third gate electrode arranged between said first n-type region and said second n-type region and extending in said second direction, and a fourth gate electrode arranged between said second n-type region and said third n-type region and extending in said second direction,
said resistor unit has a first resistor element and a second resistor element arranged in said first direction and extending in said second direction,
said capacitor unit comprises a first capacitor electrode and a second capacitor electrode,
terminal portions of said first and third gate electrodes, said first p-type region, and said first n-type region, said first resistor element and said first capacitor electrode of said first and second p-channel MIS transistor pair, and said first and second n-channel MIS transistor pair and said first resistor element and said first capacitor electrode are aligned along a straight line,
terminal portions of said second and fourth gate electrodes, said third p-type region, and said third n-type region, said second resistor element and said second capacitor electrode of said first and second p-channel MIS transistor pair and said first and second n-channel MIS transistor pair and said second resistor element and said second capacitor electrode are aligned along a straight line, and terminal portions of said second p-type region and said second n-type regions of said first and second p-channel MIS transistor pair and said first and second n-channel MIS transistor pair are aligned along a straight line in said second direction.

8. The semi-custom integrated circuit according to claim 7, wherein
said first and second p-channel MIS transistor pair or said first and second n-channel MIS transistor pair are arranged adjacent to each other.

9. The semi-custom integrated circuit according to any preceding claim, wherein
a plurality of said transistor units forms a digital circuit through an interconnection and
a plurality of resistor units and capacitor units forms an analog circuit through an internal connection.

10. The semi-custom integrated circuit according to any preceding claim, wherein said resistor and capacitor units have the same maximum dimension in said first direction as a maximum dimension in said first direction of the transistor unit.

11. The semi-custom integrated circuit according to claim 10, wherein the resistor unit is provided on the left side of the transistor unit, and the capacitor unit is provided on the right side of the transistor unit.

12. The semi-custom integrated circuit according to claim 10, wherein said basic cells are arranged in columns extending along said first direction, corresponding basic cells in adjacent columns being aligned in said second direction.

13. The semi-custom integrated circuit according to claim 10, wherein the resistor unit is provided on the right side of the transistor unit, and the capacitor unit is provided on the left side of the transistor unit.

14. The semi-custom integrated circuit according to claim 10, wherein said basic cell array is made up of first basic cells and second basic cells, each first basic cell comprising
a said transistor unit,
a said resistor unit provided on the left side of the transistor unit, and
a said capacitor unit provided on the right side of the transistor unit, and
each second basic cell comprising
a said transistor unit,
a said resistor unit provided on the right side of the transistor unit, and
a said capacitor unit provided on the left side of the transistor unit.

15. The semi-custom integrated circuit according to claim 14,
wherein the basic cell array has columns of basic cells wherein the cells are aligned in said first direction, including a column of first basic cells and an adjacent column of second basic cells.

16. The semi-custom integrated circuit according to claim 14,
wherein the basic cell array comprises a column made up of first and second basic cells arranged in turn along said first direction.

17. A semi-custom integrated circuit comprising an array of circuit elements arranged in a line, said elements comprising transistor units, capacitor units and resistor units, wherein:
said array is a basic cell array consisting of a plurality of first basic cells and a plurality of second basic cells aligned in a first direction,
each first basic cell comprising
a first resistor unit, a second resistor unit and
a transistor unit positioned between said first resistor unit and said second resistor unit;
wherein said transistor unit comprises a source region and a drain region arranged in said first direction, a gate electrode provided between said source region and drain region and extending in a second direction which is perpendicular to said first direction; each of said transistor unit, first resistor unit and second resistor unit having one or more respective terminal portions for connection of wiring;
wherein said terminal portions of said transistor unit, first resistor unit and second resistor unit are aligned along a straight line in said second direction, and
each second basic cell comprising
a first capacitor unit, a second capacitor unit and
a further transistor unit positioned between said first capacitor unit and said second capacitor unit;
wherein said further transistor unit comprises a source region and a drain region arranged in said first direction, a gate electrode provided between said source region and drain region and extending in said second direction; each of said further transistor unit, first capacitor unit and second capacitor unit having one or more respective terminal portions for connection of wiring;
wherein said terminal portions of said further transistor unit, first capacitor unit and second capacitor unit are aligned along a straight line in said second direction.

18. The semi-custom integrated circuit according to claim 17, wherein said first resistor, second resistor, first capacitor and second capacitor units have the same maximum dimension in said first direction as a maximum dimension in said first direction of said transistor unit.

19. The semi-custom integrated circuit according to claim 18,
wherein the basic cell array comprises columns of basic cells, wherein said first and second basic cells are arranged by turns along said first direction, adjacent columns having different arrangements such that corresponding cells in adjacent columns are of different types.

20. The semi-custom integrated circuit according to claim 18,
wherein the basic cell array comprises columns made up of first and second basic cells arranged along said first direction, adjacent columns having the same arrangements such that corresponding cells in adjacent columns are of the same type.

21. The semi-custom integrated circuit according to any of claims 10 to 20, wherein an array of said basic cells is connected to form an operational amplifier.

22. The semi-custom integrated circuit according to any of claims 1 to 9, wherein said resistor and capacitor units have a maximum dimension in said first direction which is a natural number times a maximum dimension in said first direction of the transistor unit.

23. The semi-custom integrated circuit according to any of claims 1 to 9, wherein said resistor and capacitor units have a maximum dimension in said first direction which is a natural number times half a maximum dimension in said first direction of the transistor unit.

24. The semi-custom integrated circuit according to claim 23, wherein said transistor unit is formed in a transistor region, and said resistor and capacitor units are formed in a wiring region provided at the side of said transistor region.

25. The semi-custom integrated circuit according to any preceding claim, wherein the terminal portions of at least one of said transistor, resistor and capacitor units are aligned along a line in said first direction.

## Patentansprüche

1. Ein semi-kundenspezifischer integrierter Schaltkreis, der ein Array aus Schaltkreiselementen umfaßt, die in einer Reihe angeordnet sind, wobei die Elemente Transistoreinheiten, Kondensatoreinheiten und Widerstandseinheiten umfassen, die genannte Transistoreinheit eine Gate-Elektrode aufweist, und eine jede der genannten Transistoreinheiten, Kondensatoreinheiten und Widerstandseinheiten eine oder mehrere jeweilige Anschlußteile aufweist, zur Verbindung mit einer Verdrahtung, dadurch gekennzeichnet, daß
das genannte Array ein Basiszellenarray ist, das aus einer Mehrzahl von Basiszellen besteht, die in einer ersten Richtung ausgerichtet sind, wobei jede Basiszelle eine der genannten Kondensatoreinheiten, der genannten Widerstandseinheiten und der genannten Transistoreinheiten aufweist, die zwischen der Kondensatoreinheit und der Widerstandseinheit positioniert ist; worin die genannte Transistoreinheit umfaßt: eine Source-Zone und eine Drain-Zone, die in der genannten ersten Richtung angeordnet sind, wobei die genannte Gate-Elektrode, die zwischen der genannten Source-Zone und der Drain-Zone vorgesehen ist sich in einer zweiten Richtung erstreckt, die senkrecht zu der genannten ersten Richtung ist, und die genannte Gate-Elektrode Anschlußteile in einem Anschlußbereich aufweist; worin die Anschlußteile der genannten Transistoreinheit, der Kondensatoreinheit und der genannten Widerstandseinheit entlang einer geraden Linie in der genannten zweiten Richtung ausgerichtet sind.

2. Der semi-kundenspezifischer integrierter Schaltkreis nach Anspruch 1, worin eine Mehrzahl der genannten Zellenarrays in der genannten zweiten Richtung angeordnet sind und einen Verdrahtungsbereich überqueren.

3. Der semi-kundenspezifischer integrierter Schaltkreis nach Anspruch 1, in dem ein nicht verwendeter Bereich der genannten Kondensatoreinheit oder der Transistoreinheit für die Anordnung einer Verbindungsverdrahtung zwischen den genannten Basiszellen verwendet wird.

4. Der semi-kundenspezifischer inteintegrierter Schaltkreis nach Anspruch 1, in dem die genannte Widerstandseinheit eine Polysiliziumschicht umfaßt, die auf einem isolierenden Film ausgebildet ist, der ein Halbleitersubstrat bedeckt und der sich in der genannten zweiten Richtung erstreckt und der einen Anschlußteil aufweist und die genannte Kondensatoreinheit eine erste Elektrode umfaßt, die auf dem isolierenden Film ausgebildet ist, um das genannte Halbleitersubstrat zu bedecken, einen isolierenden Film, um eine erste Elektrode und eine zweite Elektrode zu bedecken, die auf dem genannten isolierenden Film ausgebildet sind, wobei die erste und zweite Elektrode jeweilige Anschlußteile aufweist.

5. Der semi-kundenspezifischer inteintegrierter Schaltkreis nach Anspruch 1, in dem die genannte Transistoreinheit ein p-Kanal MIS-Transistorpaar sowie ein n-Kanal MIS-Transistorpaar umfaßt, die in der genannten zweiten Richtung angeordnet sind, wobei das p-Kanal MIS-Transistorpaar einen ersten Bereich vom p-Typ, einen zweiten Bereich vom p-Typ und einen dritten Bereich vom p-Typ umfaßt, die in der genannten ersten Richtung angeordnet sind, eine erste Gate-Elektrode, die zwischen dem genannten ersten Bereich vom p-Typ und dem genannten zweiten Bereich vom p-Typ angeordnet ist und die sich in der genannten zweiten Richtung erstreckt, sowie eine zweite Gate-Elektrode, die zwischen dem genannten zweiten Bereich vom p-Typ und dem genannten dritten Bereich vom p-Typ angeordnet ist, und die sich in der genannten zweiten Richtung erstreckt, wobei das n-Kanal MIS-Transistorpaar einen ersten Bereich vom n-Typ, einen zweiten Bereich vom n-Typ und einen dritten Bereich vom n-Typ umfaßt, die in der genannten ersten Richtung angeordnet sind, eine dritte Gate-Elektrode, die zwischen dem genannten ersten Bereich vom n-Typ und dem genannten zweiten Bereich vom n-Typ angeordnet ist und die sich in der genannten zweiten Richtung erstreckt, und eine vierte Gate-Elektrode, die in dem genannten zweiten Bereich vom n-Typ und dem genannten dritten Bereich vom n-Typ angeordnet ist und die sich in der genannten zweiten Richtung erstreckt, wobei die Widerstandseinheit ein erstes Widerstandselement und ein zweites Widerstandselement umfaßt, die in der genannten ersten Richtung angeordnet sind und sich in der genannten zweiten Richtung erstrecken, wobei die genannte Kondensatoreinheit eine erste Kondensatorelektrode und eine zweite Kondensatorelektrode aufweist, wobei die Anschlußteile der ersten und dritten Gate-Elektrode, des genannten ersten Bereiches vom p-Typ, des genannten ersten Bereiches vom n-Typ, des genannten ersten Widerstandselementes und der genannten ersten Kondensatorelektrode entlang einer Linie in der genannten zweiten Richtung ausgerichtet sind, und Anschlußteile der zweiten und vierten Gate-Elektrode, des genannten dritten Bereiches vom p-Typ, des genannten dritten Bereiches vom n-Typ, des genannten zweiten Widerstandselementes und der genannten zweiten Kondensatorelektrode miteinander ausgerichtet sind, und die Anschlußteile des genannten zweiten Bereiches vom p-Typ und des genannten zweiten Bereiches vom n-Typ entlang einer Linie in der genannten zweiten Richtung ausgerichtet sind.

6. Der semi-kundenspezifischer inteintegrierter Schaltkreis nach Anspruch 5, in dem die genannten ersten und dritten Gate-Elektroden aus einer integrierten Elektrode gebildet sind und die genannten zweiten und vierten Elektroden aus einer anderen integrierten Elektrode gebildet sind.

7. Der semi-kundenspezifischer inteintegrierter Schaltkreis nach Anspruch 1, in dem die genannte Transistoreinheit erste und zweite p-Kanal MIS-Transistorpaare sowie erste und zweite n-Kanal MIS-Transistorpaare umfaßt, die in der genannten zweiten Richtung angeordnet sind, wobei die genannten ersten und zweiten p-Kanal MIS-Transistorpaare jeweils einen ersten Bereich vom p-Typ, einen zweiten Bereich vom p-Typ und einen dritten Bereich vom p-Typ aufweisen, die in der genannten ersten Richtung angeordnet sind, eine erste Gate-Elektrode, die zwischen dem genannten ersten Bereich vom p-Typ und dem genannten zweiten Bereich vom p-Typ angeordnet ist und die sich in die genannte zweite Richtung erstreckt, sowie eine zweite Gate-Elektrode, die zwischen dem genannten zweiten Bereich vom p-Typ und dem genannten dritten Bereich vom p-Typ angeordnet ist und die sich in die genannte zweite Richtung erstreckt, wobei das genannte erste und zweite n-Kanal MIS-Transistorpaar jeweils einen ersten Bereich vom n-Typ, einen zweiten Bereich vom n-Typ und einen dritten Bereich vom n-Typ aufweist, die in der genannten ersten Richtung angeordnet sind, eine dritte Gate-Elektrode, die zwischen dem genannten ersten Bereich vom n-Typ und dem genannten zweiten Bereich vom n-Typ angeordnet ist und die sich in die genannte zweite Richtung erstreckt, und eine vierte Gate-Elektrode, die zwischen dem genannten zweiten Bereich vom n-Typ und dem genannten dritten Bereich vom n-Typ angeordnet ist und die sich in die genannte zweite Richtung erstreckt, wobei die Widerstandseinheit ein erstes Widerstandselement und ein zweites Widerstandselement aufweist, die in der genannten ersten Richtung angeordnet sind und die sich in die genannte zweite Richtung erstrecken, die genannte Kondensatoreinheit eine erste Kondensatorelektrode und eine zweite Kondensatorelektrode umfaßt, die Anschlußteile der genannten ersten und dritten Gate-Elektrode, des genannten ersten Bereiches vom p-Typ und des genannten ersten Bereiches vom n-Typ, des genannten ersten Widerstandselementes und der genannten ersten Kondensatorelektrode des genannten ersten und zweiten p-Kanal MIS-Transistorpaares, und des genannten ersten und zweiten n-Kanal MIS-Transistorpaares und des genannten ersten Widerstandselementes und der genannten ersten Kondensatorelekrode entlang einer geraden Linie ausgerichtet sind, wobei Anschlußteile der genannten zweiten und vierten Gate-Elektrode, des genannten dritten Bereiches vom p-Typ und des genannten dritten Bereiches vom n-Typ, des genannten zweiten Widerstandselementes und der genannten zweiten Kondensatorelektrode des genannten ersten und zweiten p-Kanal MIS-Transistorpaares und des genannten ersten und zweiten n-Kanal MIS-Transistorpaares und des genannten zweiten Widerstandselementes und der genannten zweiten Kondensatorelektrode entlang einer geraden Linie ausgerichtet sind, und Anschlußteile des genannten zweiten Bereiches vom p-Typ und der genannten zweiten Bereiche vom n-Typ des genannten ersten und zweiten p-Kanal MIS-Transistorpaares und des genannten ersten und zweiten n-Kanal MIS-Transistorpaares entlang einer geraden Linie in der genannten zweiten Richtung ausgerichtet sind.

8. Der semi-kundenspezifischer inteintegrierter Schaltkreis nach Anspruch 7, worin das genannte erste und zweite p-Kanal MIS-Transistorpaar oder das genannte erste und zweite n-Kanal MIS-Transistorpaar benachbart zueinander angeordnet sind.

9. Der semi-kundenspezifischer inteintegrierter Schaltkreis nach einem der vorigen Ansprüche, worin eine Mehrzahl der genannten Transistoreinheiten einen digitalen Schaltkreis durch eine Zwischenverbindung bildet, und eine Mehrzahl der Widerstandseinheiten und Kondensatoreinheiten einen analogen Schaltkreis durch eine interne Verbindung bildet.

10. Der semi-kundenspezifischer inteintegrierter Schaltkreis nach einem der vorigen Ansprüche, worin die genannten Widerstands- und Kondensatoreinheiten die gleiche maximale Abmessung in der genannten ersten Richtung aufweisen, wie eine maximale Abmessung der Transistoreinheit in der genannten ersten Richtung.

11. Der semi-kundenspezifischer inteintegrierter Schaltkreis nach Anspruch 10, worin die Widerstandseinheit auf der linken Seite der Transistoreinheit vorgesehen ist, und die Kondensatoreinheit auf der rechten Seite der Transistoreinheit vorgesehen ist.

12. Der semi-kundenspezifischer inteintegrierter Schaltkreis nach Anspruch 10, worin die genannten Basiszellen in Spalten angeordnet sind, die sich entlang der genannten ersten Richtung erstrecken, wobei entsprechende Basiszellen in benachbarten Spalten in der genannten zweiten Richtung ausgerichtet sind.

13. Der semi-kundenspezifischer inteintegrierter Schaltkreis nach Anspruch 10, worin die Widerstandseinheit auf der rechten Seite der Transistoreinheit vorgesehen ist und die Kondensatoreinheit auf der linken Seite der Transistoreinheit vorgesehen ist.

14. Der semi-kundenspezifischer inteintegrierter Schaltkreis nach Anspruch 10, worin das genannte Basiszellenarray aus ersten Basiszellen und zweiten Basiszellen aufgebaut wird, wobei eine jede der ersten Basiszellen eine genannte Transistoreinheit umfaßt, eine genannte Widerstandseinheit, die auf der linken Seite der Transistoreinheit vorgesehen ist, und eine genannte Kondensatoreinheit, die auf der rechten Seite der Transistoreinheit vorgesehen ist, und eine jede zweite Basiszelle eine genannte Transistoreinheit umfaßt, eine genannte Widerstandseinheit, die auf der rechten Seite der Transistoreinheit vorgesehen ist, und eine genannte Kondensatoreinheit, die auf der linken Seite der Transistoreinheit vorgesehen ist.

15. Der semi-kundenspezifischer inteintegrierter Schaltkreis nach Anspruch 14, worin das Basiszellenarray Spalten aus Basiszellen aufweist, worin die Zellen in der genannten ersten Richtung ausgerichtet sind, einschließlich einer Spalte aus ersten Basiszellen und einer benachbarten Spalte aus zweiten Basiszellen.

16. Der semi-kundenspezifischer inteintegrierter Schaltkreis nach Anspruch 14, worin das Basiszellenarray eine Spalte umfaßt, die aus ersten und zweiten Basiszellen aufgebaut ist, die abwechselnd entlang der genannten ersten Richtung angeordnet sind.

17. Ein semi-kundenspezifischer integrierter Schaltkreis, der ein Array aus Schaltkreiselementen umfaßt, die in einer Reihe angeordnet sind, wobei die genannten Elemente Transistoreinheiten, Kondensatoreinheiten und Widerstandseinheiten umfassen, worin das genannte Array ein Basiszellenarray ist, das aus einer Mehrzahl aus ersten Basiszellen und einer Mehrzahl aus zweiten Basiszellen besteht, die in einer ersten Richtung ausgerichtet sind, jede erste Basiszelle eine erste Widerstandseinheit umfaßt, eine zweite Widerstandseinheit und eine Transistoreinheit, die zwischen der genannten ersten Widerstandseinheit und der genannten zweiten Widerstandseinheit angeordnet ist; worin die genannte Transistoreinheit eine Source-Zone und eine Drain-Zone umfaßt, die in der genannten ersten Richtung angeordnet sind, eine Gate-Elektrode, die zwischen der genannten Source-Zone und der Drain-Zone vorgesehen ist und die sich in eine zweite Richtung erstreckt, die senkrecht zu der genannten ersten Richtung ist; eine jede der genannten Transistoreinheit, der ersten Widerstandseinheit und der zweiten Widerstandseinheit eine oder mehrere jeweilige Anschlußteile aufweist, zur Verbindung mit der Verdrahtung; worin die genannten Anschlußteile der genannten Transistoreinheit, der ersten Widerstandseinheit und der zweiten Widerstandseinheit entlang einer geraden Linie in der genannten zweiten Richtung ausgerichtet sind, und jede zweite Basiszelle eine erste Kondensatoreinheit, eine zweite Kondensatoreinheit und eine weitere Transistoreinheit umfaßt, die zwischen der genannten ersten Kondensatoreinheit und der genannten zweiten Kondensatoreinheit positioniert ist; worin die genannte weitere Transistoreinheit eine Source-Zone und eine Drain-Zone umfaßt, die in der genannten ersten Richtung angeordnet sind, eine Gate-Elektrode, die zwischen der genannten Source-Zone und der Drain-Zone vorgesehen ist und die sich in die genannte zweite Richtung erstreckt, eine jede der genannten weiteren Transistoreinheit, der ersten Kondensatoreinheit und der zweiten Kondensatoreinheit eine oder mehrere jeweilige Anschlußteile aufweist, für die Verbindung mit einer Verdrahtung; worin die genannten Anschlußteile der genannten weiteren Transistoreinheit, der ersten Kondensatoreinheit und der zweiten Kondensatoreinheit entlang einer geraden Linie in der genannten zweiten Richtung ausgerichtet sind.

18. Der semi-kundenspezifischer inteintegrierter Schaltkreis nach Anspruch 17, worin die genannte erste Widerstands-, zweite Widerstands-, erste Kondensator- und zweite Kondensatoreinheit die gleiche maximale Abmessung in der genannten ersten Richtung aufweisen wie eine maximale Abmessung der genannten Transistoreinheit in der genannten ersten Richtung.

19. Der semi-kundenspezifischer inteintegrierter Schaltkreis nach Anspruch 18, worin das Basiszellenarray Spalten aus Basiszellen umfaßt, worin die genannten ersten und zweiten Basiszellen abwechselnd entlang der genannten ersten Richtung angeordnet sind, benachbarte Spalten unterschiedliche Anordnungen derart aufweisen, daß entsprechende Zellen in benachbarten Spalten von unterschiedlichem Typ sind.

20. Der semi-kundenspezifischer inteintegrierter Schaltkreis nach Anspruch 18, worin das Basiszellenarray Spalten umfaßt, die aus ersten und zweiten Basiszellen aufgebaut sind, die entlang der genannten ersten Richtung angeordnet sind, wobei benachbarte Spalten die gleichen Anordnungen derart aufweisen, daß entsprechende Zellen in benachbarten Spalten vom gleichen Typ sind.

21. Der semi-kundenspezifischer inteintegrierter Schaltkreis nach einem der Ansprüche 10 bis 20, worin ein Array aus den genannten Basiszellen derart verbunden ist, daß es einen Operationsverstärker bildet.

22. Der semi-kundenspezifischer inteintegrierter Schaltkreis nach einem der Ansprüche 1 bis 9, worin die genannten Widerstands- und Kondensatoreinheiten eine maximale Abmessung in der genannten ersten Richtung aufweisen, die eine natürliche Zahl mal einer maximalen Abmessung der Transistoreinheit in der genannten ersten Richtung ist.

23. Der semi-kundenspezifischer inteintegrierter Schaltkreis nach einem der Ansprüche 1 bis 9, worin die genannten Widerstands- und Kondensatoreinheiten eine maximale Abmessung in der genannten ersten Richtung aufweisen, die eine natürliche Zahl mal der Hälfte einer maximalen Abmessung der Transistoreinheit in der genannten ersten Richtung ist.

24. Der semi-kundenspezifischer inteintegrierter Schaltkreis nach Anspruch 23, worin die genannte Transistoreinheit in einem Transistorbereich ausgebildet ist und die genannten Widerstands- und Kondensatoreinheiten in einem Verdrahtungsbereich ausgebildet sind, der an der Seite des genannten Transistorbereiches vorgesehen ist.

25. Der semi-kundenspezifischer inteintegrierter Schaltkreis nach einem der vorigen Ansprüche, worin die Anschlußteile von wenigstens einer der genannten Transistor-, Widerstands- und Kondensatoreinheiten entlang einer Linie in der genannten ersten Richtung ausgerichtet sind.

## Revendications

1. Circuit intégré semi-personnalisé comprenant un réseau d'éléments de circuit agencés selon une ligne, lesdits éléments comprenant des unités de transistor, des unités de capacité et des unités de résistance, ladite unité de transistor comportant une électrode de grille et chaque unité prise parmi ladite unité de transistor, ladite unité de capacité et ladite unité de résistance comportant au moins des parties de bornes respectives permettant la connexion d'un câblage,
caractérisé en ce que :
ledit réseau est un réseau de cellules de base constitué par une pluralité de cellules de base alignées suivant une première direction, chaque cellule de base comportant une dite unité de capacité, une dite unité de résistance et une dite unité de transistor positionnée entre l'unité de capacité et l'unité de résistance,
dans lequel ladite unité de transistor comprend :
une région de source et une région de drain agencées suivant ladite première direction ;
ladite électrode de grille prévue entre ladite région de source et ladite région de drain et s'étendant suivant une seconde direction qui est perpendiculaire à ladite première direction ; et
ladite électrode de grille comportant des parties de bornes au niveau d'une région de bornes ;
dans lequel lesdites parties de bornes de ladite unité de transistor, de ladite unité de capacité et de ladite unité de résistance sont alignées suivant une ligne rectiligne suivant ladite seconde direction.

2. Circuit intégré semi-personnalisé selon la revendication 1, dans lequel une pluralité desdits réseaux de cellules sont agencés suivant ladite seconde direction qui croise une région de câblage.

3. Circuit intégré semi-personnalisé selon la revendication 1, dans lequel une région inutilisée de ladite unité de capacité ou de ladite unité de transistor est utilisée pour l'agencement d'un câblage d'interconnexion entre lesdites cellules de base.

4. Circuit intégré semi-personnalisé selon la revendication 1, dans lequel :
ladite unité de résistance comprend une couche en silicium polycristallin ou polysilicium formée sur un film isolant recouvrant un substrat semiconducteur et s'étendant suivant ladite seconde direction et comportant une partie de borne ; et
ladite unité de capacité comprend une première électrode formée sur le film isolant pour recouvrir ledit substrat semiconducteur, un film isolant pour recouvrir une première électrode et une seconde électrode formée sur ledit film isolant, lesdites première et seconde électrodes comportant des parties de bornes respectives.

5. Circuit intégré semi-personnalisé selon la revendication 1, dans lequel :
ladite unité de transistor comprend une paire de transistors métal-isolant-semiconducteur (MIS) à canal P et une paire de transistors MIS à canal N agencés suivant ladite seconde direction ;
ladite paire de transistors MIS à canal P comprend une première région de type P, une seconde région de type P et une troisième région de type P qui sont agencées suivant ladite première direction, une première électrode de grille agencée entre ladite première région de type P et ladite seconde région de type P et s'étendant suivant ladite seconde direction et une seconde électrode de grille agencée entre ladite seconde région de type P et ladite troisième région de type P et s'étendant suivant ladite seconde direction ;
ladite paire de transistors MIS à canal N comprend une première région de type N, une seconde région de type N et une troisième région de type N qui sont agencées suivant ladite première direction, une troisième électrode de grille agencée entre ladite première région de type N et ladite seconde région de type N et s'étendant suivant ladite seconde direction et une quatrième électrode de grille agencée entre ladite seconde région de type N et ladite troisième région de type N et s'étendant suivant ladite seconde direction ;
ladite unité de résistance comprend un premier élément de résistance et un second élément de résistance agencés suivant ladite première direction et s'étendant suivant ladite seconde direction ;
ladite unité de capacité comporte une première électrode de capacité et une seconde électrode de capacité ;
des parties de bornes des première et troisième électrodes de grille, de ladite première région de type P, de ladite première région de type N, dudit premier élément de résistance et de ladite première électrode de capacité sont alignées selon une ligne suivant ladite seconde direction ;
des parties des seconde et quatrième électrodes de grille, de ladite troisième région de type P, de ladite troisième région de type N, dudit second élément de résistance et de ladite seconde électrode de capacité sont alignées les unes avec les autres et les parties de bornes de ladite seconde région de type P et de ladite seconde région de type N sont alignées selon une ligne suivant ladite direction.

6. Circuit intégré semi-personnalisé selon la revendication 5, dans lequel :
lesdites première et troisième électrodes de grille sont constituées par une électrode intégrée et lesdites seconde et quatrième électrodes sont constituées par une autre électrode intégrée.

7. Circuit intégré semi-personnalisé selon la revendication 1, dans lequel :
ladite unité de transistor comprend des première et seconde paires de transistors MIS à canal P et des première et seconde paires de transistors MIS à canal N agencés suivant ladite seconde direction ;
lesdites première et seconde paires de transistors MIS à canal P comprennent chacune une première région de type P, une seconde région de type P et une troisième région de type P agencées suivant ladite première direction, une première électrode de grille agencée entre ladite première région de type P et ladite seconde région de type P et s'étendant suivant ladite seconde direction et une seconde électrode de grille agencée entre ladite seconde région de type P et ladite troisième région de type P et s'étendant suivant ladite seconde direction ;
lesdites première et seconde paires de transistors MIS à canal N comprennent chacune une première région de type N, une seconde région de type N et une troisième région de type N agencées suivant ladite première direction, une première électrode de grille agencée entre ladite première région de type N et ladite seconde région de type N et s'étendant suivant ladite seconde direction et une quatrième électrode de grille agencée entre ladite seconde région de type N et ladite troisième région de type N et s'étendant suivant ladite seconde direction ;
ladite unité de résistance comprend un premier élément de résistance et un second élément de résistance agencés suivant ladite première direction et s'étendant suivant ladite seconde direction ;
ladite unité de capacité comporte une première électrode de capacité et une seconde électrode de capacité ;
des parties de bornes des première et troisième électrodes de grille, de ladite première région de type P, de ladite première région de type N, dudit premier élément de résistance et de ladite première électrode de capacité desdites première et seconde paires de transistors MIS à canal P et desdites première et seconde paires de transistors MIS à canal N et dudit élément de résistance et de ladite première électrode de capacité sont alignées suivant une ligne rectiligne ;
des parties de bornes desdites seconde et quatrième électrodes de grille, de ladite troisième région de type P et de ladite troisième région de type N, dudit second élément de résistance et de ladite troisième région de type P et de ladite troisième région de type N, dudit second élément de résistance et de ladite seconde électrode de capacité desdites première et seconde paires de transistors MIS à canal P et desdites première et seconde paires de transistors MIS à canal N et dudit second élément de résistance et de ladite seconde électrode de capacité sont alignées suivant une ligne rectiligne et des parties de bornes de ladite seconde région de type P et desdites secondes régions de type N desdites première et seconde paires de transistors MIS à canal P et desdites première et seconde paires de transistors MIS à canal N sont alignées selon une ligne rectiligne suivant ladite seconde direction.

8. Circuit intégré semi-personnalisé selon la revendication 7, dans lequel lesdites première et seconde paires de transistors MIS à canal P ou lesdites première et seconde paires de transistors MIS à canal N sont agencées de manière à être adjacentes l'une à l'autre.

9. Circuit intégré semi-personnalisé selon l'une quelconque des revendications précédentes, dans lequel :
une pluralité desdites unités de transistor forment un circuit numérique par l'intermédiaire d'une interconnexion ; et
une pluralité d'unités de résistance et d'unités de capacité forment un circuit analogique par l'intermédiaire d'une connexion interne.

10. Circuit intégré semi-personnalisé selon l'une quelconque des revendications précédentes, dans lequel lesdites unités de résistance et de capacité présentent la même dimension maximum suivant ladite première direction de l'unité de transistor.

11. Circuit intégré semi-personnalisé selon la revendication 10, dans lequel l'unité de résistance est prévue sur le côté gauche de l'unité de transistor et l'unité de capacité est prévue sur le côté droit de l'unité de transistor.

12. Circuit intégré semi-personnalisé selon la revendication 10, dans lequel lesdites cellules de base sont agencées selon des colonnes s'étendant suivant ladite première direction, des cellules de base correspondantes contenues dans des colonnes adjacentes étant alignées suivant ladite seconde direction.

13. Circuit intégré semi-personnalisé selon la revendication 10, dans lequel l'unité de résistance est prévue sur le côté droit de l'unité de transistor et l'unité de capacité est prévue sur le côté gauche de l'unité de transistor.

14. Circuit intégré semi-personnalisé selon la revendication 10, dans lequel ledit réseau de cellules de base est constitué par des premières cellules de base et par des secondes cellules de base, chaque première cellule de base comprenant :
une dite unité de transistor ;
une dite unité de résistance prévue sur le côté gauche de l'unité de transistor ; et
une dite unité de capacité prévue sur le côté droit de l'unité de transistor ; et
chaque dite seconde cellule de base comprenant :
une dite unité de transistor ;
une dite unité de résistance prévue sur le côté droit de l'unité de transistor ; et
une dite unité de capacité prévue sur le côté gauche de l'unité de transistor.

15. Circuit intégré semi-personnalisé selon la revendication 14,
dans lequel le réseau de cellules de base comporte des colonnes de cellules de base, les cellules étant alignées suivant ladite première direction, y compris une colonne de premières cellules de base et une colonne adjacente de secondes cellules de base.

16. Circuit intégré semi-personnalisé selon la revendication 14,
dans lequel le réseau de cellules de base comprend une colonne constituée par des première et seconde cellules de base agencées suivant ladite première direction.

17. Circuit intégré semi-personnalisé comprenant un réseau d'éléments de circuit agencés selon une ligne, lesdits éléments comprenant des unités de transistor, des unités de capacité et des unités de résistance, dans lequel :
ledit réseau est un réseau de cellules de base constitué par une pluralité de premières cellules de base et par une pluralité de secondes cellules de base alignées selon une première direction ;
chaque première cellule de base comprenant :
une première unité de résistance, une seconde unité de résistance et une unité de transistor positionnée entre ladite première unité de résistance et ladite seconde unité de résistance ; dans lequel ladite unité de transistor comprend une région de source et une région de drain agencées suivant ladite première direction, une électrode de grille prévue entre ladite région de source et ladite région de drain et s'étendant suivant une seconde direction qui est perpendiculaire à ladite première direction ;
chaque unité prise parmi ladite unité de transistor, ladite première unité de résistance et ladite seconde unité de résistance comportant une ou plusieurs parties de bornes respectives en vue d'une connexion d'un câblage ;
dans lequel lesdites parties de bornes de ladite unité de transistor, de ladite première unité de résistance et de ladite seconde unité de résistance sont alignées selon une ligne rectiligne suivant ladite seconde direction ; et
chaque seconde cellule de base comprenant :
une première unité de capacité, une seconde unité de capacité ; et
une unité de transistor supplémentaire positionnée entre ladite première unité de capacité et ladite seconde unité de capacité ;
dans lequel ladite unité de transistor supplémentaire comprend une région de source et une région de drain agencées suivant ladite première direction, une électrode de grille prévue entre ladite région de source et ladite région de drain et s'étendant suivant ladite seconde direction ;
chaque unité prise parmi ladite unité de transistor supplémentaire, ladite première unité de capacité et ladite seconde unité de capacité comportant une ou plusieurs parties de bornes respectives en vue d'une connexion d'un câblage ;
dans lequel lesdites parties de bornes de ladite unité de transistor supplémentaire, de ladite première unité de capacité et de ladite seconde unité de capacité sont alignées selon une ligne rectiligne suivant ladite seconde direction.

18. Circuit intégré semi-personnalisé selon la revendication 17, dans lequel ladite première unité de résistance, ladite seconde unité de résistance, ladite première unité de capacité et ladite seconde unité de capacité présentent la même dimension maximum suivant ladite première direction que la dimension maximum suivant ladite première direction de ladite unité de transistor.

19. Circuit intégré semi-personnalisé selon la revendication 18, dans lequel le réseau de cellules de base comprend des colonnes de cellules de base, dans lequel lesdites première et seconde cellules de base sont agencées suivant ladite première direction, des colonnes adjacentes présentant des agencements différents de telle sorte que des cellules correspondantes contenues dans des colonnes adjacentes soient de types différents.

20. Circuit intégré semi-personnalisé selon la revendication 18, dans lequel le réseau de cellules de base comprend des colonnes constituées par des premières et secondes cellules de base agencées suivant ladite première direction, des colonnes adjacentes comportant les mêmes agencements de telle sorte que des cellules correspondantes contenues dans des colonnes adjacentes soient du même type.

21. Circuit intégré semi-personnalisé selon l'une quelconque des revendications 10 à 20, dans lequel un réseau desdites cellules de base est connecté pour former un amplificateur opérationnel.

22. Circuit intégré semi-personnalisé selon l'une quelconque des revendications 1 à 9, dans lequel lesdites unités de résistance et de capacité présentent une dimension maximum suivant ladite première direction qui est égale à un nombre entier de fois une dimension maximum suivant ladite première direction de l'unité de transistor.

23. Circuit intégré semi-personnalisé selon l'une quelconque des revendications 1 à 9, dans lequel lesdites unités de résistance et de capacité présentent une dimension maximum suivant ladite première direction qui est égale à un nombre entier de fois la moitié d'une dimension maximum suivant ladite première direction de l'unité de transistor.

24. Circuit intégré semi-personnalisé selon la revendication 23, dans lequel ladite unité de transistor est formée dans une région de transistors et lesdites unités de résistance et de capacité sont formées dans une région de câblage prévue au niveau du côté de ladite région de transistors.

25. Circuit intégré semi-personnalisé selon l'une quelconque des revendications précédentes, dans lequel les parties de bornes d'au moins une unité prise parmi ladite unité de transistor, ladite unité de résistance et ladite unité de capacité sont alignées selon une ligne suivant ladite première direction.
